# EUROPÄISCHE PATENTSCHRIFT

(11) **EP 0 378 113 B1**
(45) Veröffentlichungstag und Bekanntmachung des Hinweises auf die Patenterteilung: **14.09.1994**
(21) Anmeldenummer: 90100168.5
(22) Anmeldetag: 04.01.1990
(51) Int. Cl.: H05K 3/34, B23K 3/04

(54) **Lötvorrichtung mit mindestens einer Bügelelektrode**
Soldering device with at least one bow-shaped electrode
Dispositif à souder ayant au moins une électrode recourbée en arc

(30) Priorität: 10.01.1989 DE 3900522
(43) Veröffentlichungstag der Anmeldung: 18.07.1990
(73) Patentinhaber: SIEMENS AKTIENGESELLSCHAFT, 80333 München (DE)
(72) Erfinder: Schuster, Rudolf, D-8011 Heimstetten (DE); Ketzer, Georg, D-8025 Unterhaching (DE)

(56) Entgegenhaltungen:
- CH-A- 272 011
- DE-A- 3 534 851
- US-A- 4 851 648
- F & M - FEINWERKTECHNIK& MESSTECHNIK Band 96, Nr. 9, September 1988,Seiten 387-389, München, DE; G. ZSCHIMMER: "Montage vielpoliger Bauteile durch Impulslöten"

## Beschreibung

Die Erfindung betrifft eine Lötvorrichtung mit mindestens einer Bügelelektrode, deren rechteckförmige Arbeitsfläche auf die Lötstelle aufsetzbar ist.

Eine derartige Lötvorrichtung ist beispielsweise aus der DE-A-31 49 236 bekannt. Der Elektrodenhalter dieser bekannten Lötvorrichtung umfaßt elektrisch voneinander isolierte, kleine Säulen aus leitfähigem Material, zwischen deren Enden in auswechselbarer Weise mindestens zwei Bügelelektroden befestigt sind. Die U-förmigen Bügelelektroden, die durch elektrische Widerstandswärme erhitzt werden können, sind aus einer ebenen Platte mit einem Widerstandsmaterial wie Tantal oder Molybdän hergestellt und in der Weise angebracht, daß sie mit ihren auf der Unterseite liegenden Arbeitsflächen in Kontakt mit den zu verlötenden Elementen kommen. Bei einer Anzahl von zwei einander gegenüberliegenden Bügelelektroden oder vier paarweise einander gegenüberliegenden Bügelelektroden werden für die Elektrodenhalter insgesamt vier kleine Säulen benötigt, die auf einer jeweiligen Diagonalen des Querschnitts der Lötvorrichtung angeordnet sind und durch mehrere kreuzförmige Verstrebungen mechanisch miteinander verbunden sind. Zur Stromversorgung von vier Bügelelektroden werden zwei auf einer Diagonale liegende kleine Säulen mit dem einen Pol einer Stromquelle verbunden, während die beiden anderen kleinen Säulen mit dem anderen Pol der Stromquelle verbunden werden.

Lötvorrichtungen mit zwei parallel einander gegenüberliegenden Bügelelektroden oder mit vier paarweise einander gegenüberliegenden Bügelelektroden werden insbesondere für das Auflöten hochpoliger elektronischer Bauelemente wie Mikropacks, Flatpacks und dergleichen auf Leiterplatten eingesetzt, wobei die Widerstandserwärmung der Bügelelektroden durch Stromimpulse vorgenommen wird. Dabei muß sowohl vor dem Lötvorgang als auch während der gesamten Dauer des Lötvorganges ein sicherer Kontakt zwischen den Arbeitsflächen der Bügelelektroden, den Anschlußbeinchen der Bauelemente und den Leiterbahnen bzw. Anschlußpads der Leiterplatten gewährleistet sein. Diese Forderung kann jedoch im Hinblick auf gegebenenfalls auftretende Wölbungen der Leiterplatten, auf Toleranzen der Leiterplatten in der zur Leiterplattenebene senkrechten Richtung, auf Schichtdickentoleranzen und auf eine mögliche Schiefstellung der Leiterplatten beim Lötprozeß nicht immer erfüllt werden.

Der Erfindung liegt daher die Aufgabe zugrunde, eine Lötvorrichtung der eingangs genannten Art so zu verbessern, daß vor dem Lötvorgang und während des Lötvorganges mit Sicherheit ein ausreichender Kontakt zwischen den Arbeitsflächen der Bügelelektroden, den Anschlußbeinchen der Bauelemente und den Leiterbahnen bzw. Anschlußpads der Leiterplatten gewährleistet ist.

Die Lösung dieser Aufgabe erfolgt erfindungsgemäß durch eine schwenkbare Aufhängung der Bügelelektrode mit der Mittelsenkrechten der längeren Seiten der Arbeitsfläche als ausgelagerte, in der Ebene der Arbeitsfläche liegende Drehachse.

Der Erfindung liegt die Erkenntnis zugrunde, daß eine schwenkbare Aufhängung der Bügelelektrode, d.h. bei zwei oder vier Bügelelektroden eine schwenkbare Einzelaufhängung jeder einzelnen dieser Bügelelektroden, dann einen optimalen Parallelitätsausgleich zwischen der jeweiligen Arbeitsfläche und der Leiterplatte ermöglicht, wenn die hierzu erforderlichen Schwenkbewegungen um eine ausgelagerte, mittig in der Ebene der Arbeitsfläche liegende und senkrecht zur Seitenfläche der Bügelelektrode ausgerichtete Drehachse vorgenommen wird. Nur bei einer derartigen Lage der Drehachse können beim Aufsetzen der Arbeitsfläche auf die Lötstelle unerwünschte und schädliche Kraftübertragungen in Richtung der Leiterplattenebene vermieden werden. Beim Aufsetzen auf die Lötstelle werden für den Parallelitätsausgleich allenfalls geringe Normalkräfte auf die Leiterplatte übertragen. Der für den Lötvorgang erforderliche höhere Druck wird dann erst nach dem Parallelitätsausgleich, d.h. ausschließlich als Normalkraft aufgebracht.

Gemäß einer bevorzugten Ausgestaltung der Erfindung ist vorgesehen, daß die Bügelelektrode über eine Lenkerführung mit zwei Schwingen um die ausgelagerte Drehachse schwenkbar an einem Halter befestigt ist. Mit einer derartigen Lenkerführung kann die schwenkbare Aufhängung der Bügelelektrode um eine ausgelagerte Drehachse auf besonders einfache Weise realisiert werden.

Gemäß einer weiteren bevorzugten Ausgestaltung der Erfindung ist vorgesehen, daß die Bügelelektrode um die ausgelagerte Drehachse schwenkbar an einem Halter befestigt ist und daß der Halter in vertikaler Richtung heb- und senkbar und in horizontaler Richtung von der Lötstelle weg nach außen verfahrbar angeordnet ist. Bei dieser Anordnung ist es einerseits möglich den Lötbügel mit der für den Lötvorgang erforderlichen Normalkraft auf die Lötstelle zu drücken, während andererseits der Lötbügel vor dem Aufsetzen auf die Lötstelle oder nach dem Abheben von der Löstelle nach außen verfahren werden kann und damit eine freie Sicht auf die Lötstelle von oben her ermöglicht wird. Diese Bewegung der Bügelelektrode kann dadurch auf besonders einfache Weise realisiert werden, daß der Halter starr mit der Koppel einer Viergelenkkette verbunden ist. In diesem Fall ist es dann besonders günstig, wenn die Koppelkurve der Viergelenkkette in der Nähe der Lötstelle ausschließlich in vertikaler Richtung verläuft und die Komponente in horizontaler Richtung erst mit zunehmender Entfernung von der Lötstelle größer wird. Mit einer derartigen Ausgestaltung der Koppelkurve ist mit Sicherheit gewährleistet, daß auf die Lötstelle ausschließlich Normalkräfte übertragen werden.

Vorzugsweise ist jeder Bügelelektrode einer Lötvorrichtung ein separat antreibbarer Halter zugeordnet, so daß bei Vorrichtungen mit zwei einander gegenüberliegenden Bügelelektroden oder vier paarweise einander gegenüberliegenden Bügelelektroden jede einzelne Bügelelektrode nach außen verfahren werden kann und damit eine optimale Sicht auf die Lötstelle ermöglicht wird. Bei einer Lötvorrichtung mit vier paarweise einander gegenüberliegenden Bügelelektroden kann die visuelle Überwachung des Lötvorganges dann dadurch noch weiter verbessert werden, daß die Bügelelektroden nacheinander paarweise auf die Lötstelle aufsetzbar sind.

Ausführungsbeispiele der Erfindung sind in der Zeichnung dargestellt und werden im folgenden näher beschrieben.

Es zeigen
- Fig. 1: das stark vereinfachte Prinzip einer erfindungsgemäßen Lötvorrichtung mit einer schwenkbaren Einzelaufhängung eines U-förmigen Flachlötbügels,
- Fig. 2: eine Lenkerführung zur schwenkbaren Einzelaufhängung eines U-förmigen Flachlötbügels an einem Halter und
- Fig. 3: das Prinzip einer Viergelenkkette als Antriebsvorrichtung des in Fig. 2 dargestellten Halters.

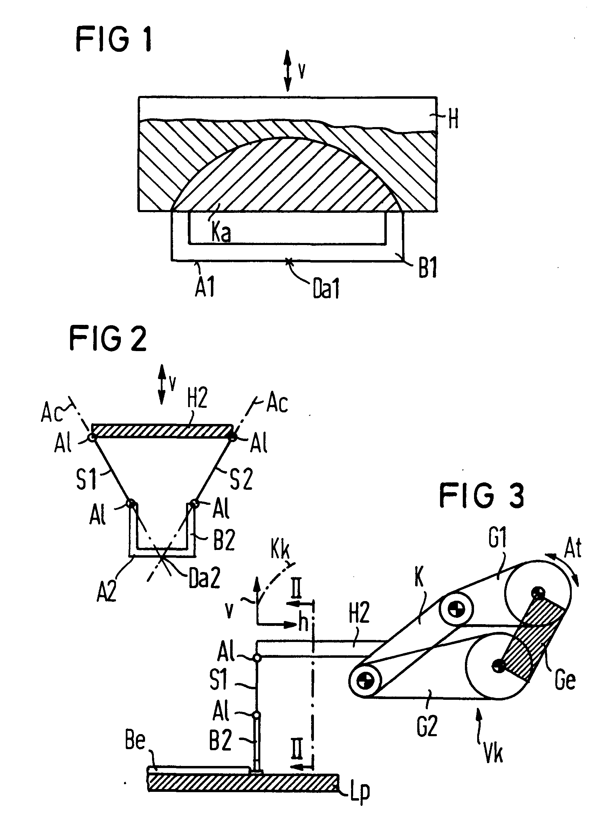

Fig. 1 zeigt in stark vereinfachter schematischer Darstellung des Grundprinzip einer erfindungsgemäßen Vorrichtung, wobei die zum Verständnis der Erfindung nicht erforderlichen Teile wie Stromzuführungen und dergleichen weggelassen wurden. Die dargestellte Lötvorrichtung besitzt einen aus einer ebenen Platte herausgebildeten U-förmigen Flachlötbügel B1, dessen auf der Unterseite liegende rechteckförmige Arbeitsfläche A1 durch Bewegungen eines Halters H1 in vertikaler Richtung v auf eine Lötstelle aufgesetzt wird bzw. nach Beendigung des Lötvorganges von der Lötstelle abgehoben wird. Der Flachlötbügel B1 ist dabei im Halter H1 schwenkbar aufgehängt, wobei die ausgelagerte und in der Ebene der Arbeitsfläche A1 liegende Drehachse dieser schwenkbaren Aufhängung mit Dal bezeichnet ist. Die in Fig. 1 durch ein Kreuz angedeutete und senkrecht zur Zeichnungsebene verlaufende Drehachse Da1 ist in der Mitte der längeren Seite der Arbeitsfläche A1 angeordnet und senkrecht zur Seitenfläche des Flachlötbügels B1 ausgerichtet. Die beim Aufsetzen des Flachlötbügels B1 auf eine Lötstelle zur Erzielung eines optimalen Kontaktes gegebenenfalls erforderliche Schwenkbewegung um die ausgelagerte, d.h. körperlich nicht vorhandene Drehachse Dal wird bei dem in Fig. 1 dargestellten Prinzip dadurch ermöglicht, daß der Flachlötbügel B1 an einem Kreisscheibenabschnitt Ka befestigt ist, dessen Achse der Drehachse Dal entspricht und der in einer entsprechenden kreisscheibenförmigen Ausnehmnung des Halters H1 angeordnet ist. Bei einer Realisierung des hier stark vereinfacht dargestellten Prinzips müßte natürlich durch zusätzliche Maßnahmen der körperliche Zusammenhalt zwischen Halter H1 und Kreisscheibenabschnitt Ka gewährleistet werden.

Gemäß Fig. 2 kann die schwenkbare Aufhängung eines U-förmigen Flachlötbügels B2 an einem Halter H2 auch durch eine Lenkerführung realisiert werden. Diese Lenkerführung umfaßt zwei Schwingen S1 und S2, deren Enden jeweils an den Halter H2 und an den Flachlötbügel B2 angelenkt sind. Die Drehachsen der mit A1 bezeichneten Anlenkungen der Schwingen S1 und S2 an den Halter H2 und den Flachlötbügel B2 sind dabei parallel zu der hier mit Da2 bezeichneten Drehachse der schwenkbaren Aufhängung ausgerichtet. Eine exakte Schwenkung des Flachlötbügels B2 um die Drehachse Da2 wird bei der dargestellten Lenkerführung dadurch ermöglicht, daß die mit Ac bezeichneten Längsachsen der Schwingen S1 und S2 sich in der Mitte der Arbeitsfläche A2 des Flachlötbügels B2 schneiden. Der Schnittpunkt der Achsen Ac liegt also in der Drehachse Da2.

Die in Fig. 2 im Prinzip dargestellte Lenkerführung des Flachlötbügels B2 entspricht einem Schnitt gemäß der Linie II-II der Fig. 3. Dabei ist in Fig. 3 zusätzlich zu erkennen, daß der Halter H2 starr mit der Koppel K einer Viergelenkkette Vk verbunden ist, deren Gestell mit Ge und deren beide anderen Glieder mit G1 und G2 bezeichnet sind. Ein gestellseitiger Antrieb des Gliedes G1, beispielsweise über einen DC-Motor, ist lediglich durch einen Doppelpfeil At angedeutet.

Die in Fig. 3 lediglich im Prinzip dargestellte angetriebene Viergelenkkette Vk hat die Aufgabe, den Flachlötbügel B2 sowohl in vertikaler Richtung v als auch in horizontaler Richtung h bewegen zu können. Die über die Achsen v und h strichpunktiert aufgetragene Koppelkurve Kk ist dabei so ausgelegt, daß der Flachlötbügel B2 beim Abheben bzw. Aufsetzen zunächst nur in vertikaler Richtung v bewegt wird und daß dann mit zunehmendem Abstand von der Lötstelle eine Bewegung in horizontaler Richtung h überlagert wird. Diese Bewegung in horizontaler Richtung h ist dabei von dem auf eine Leiterplatte Lp aufzubringenden Bauelement Be weg nach außen gerichtet, so daß bei abgehobenem Flachlötbügel B2 eine freie Sicht auf das Bauelement Be und die Lötstelle möglich ist.

Das in den Fig. 2 und 3 dargestellte Aufhängungs- und Bewegungsprinzip des Flachlötbügels B2 kann auf einfache Weise auf Lötvorrichtungen mit zwei einander gegenüberliegenden Flachlötbügeln oder mit vier paarweise einander gegenüberliegenden Flachlötbügeln übertragen werden, wenn die entsprechenden Halter jeweils von der Lötstelle weg nach außen gerichtet sind. Bei einer Lötvorrichtung mit vier paarweise einander gegenüberliegenden Bügelelektroden können dann die Bügelelektroden nacheinander paarweise auf die Lötstelle aufgesetzt werden. Hierdurch wird eine optimale Überwachung des Lötvorganges ermöglicht, während durch die schwenkbare Einzelaufhängung jeder einzelnen Bügelelektrode ein optimaler Kontakt der jeweiligen Arbeitsfläche mit der Lötstelle gewährleistet ist.

## Patentansprüche

1. Lötvorrichtung mit mindestens einer Bügelelektrode (B1;B2), deren rechteckförmige Arbeitsfläche (A1;A2) auf die Lötstelle aufsetzbar ist,
**gekennzeichnet durch**
eine schwenkbare Aufhängung der Bügelelektrode (B1;B2) mit der Mittelsenkrechten der längeren Seiten der Arbeitsfläche (A1;A2) als ausgelagerte, in der Ebene der Arbeitsfläche (A1;A2) liegende Drehachse (Da1;Da2).

2. Lötvorrichtung nach Anspruch 1,
**dadurch gekennzeichnet**,
daß die Bügelelektrode (B2) über eine Lenkerführung mit zwei Schwingen (S1,S2) um die ausgelagerte Drehachse (Da2) schwenkbar an einem Halter (H2) befestigt ist.

3. Lötvorrichtung nach Anspruch 1 oder 2,
**dadurch gekennzeichnet**,
daß die Bügelelektrode (B2) um die ausgelagerte Drehachse (Da2) schwenkbar an einem Halter (H2) befestigt ist und daß der Halter (H2) in vertikaler Richtung (v) heb- und senkbar und in horizontaler Richtung (h) von der Lötstelle weg nach außen verfahrbar angeordnet ist.

4. Lötvorrichtung nach Anspruch 3,
**dadurch gekennzeichnet**,
daß der Halter (H2) starr mit der Koppel (K) einer Viergelenkkette (Vk) verbunden ist.

5. Lötvorrichtung nach Anspruch 4,
**dadurch gekennzeichnet**,
daß die Koppelkurve (Kk) der Viergelenkkette (Vk) in der Nähe der Lötstelle ausschließlich in vertikaler Richtung (v) verläuft und daß die Komponente in horizontaler Richtung (h) erst mit zunehmender Entfernung von der Lötstelle größer wird.

6. Lötvorrichtung nach einem der Ansprüche 3 bis 5,
**dadurch gekennzeichnet**,
daß jeder Bügelelektrode (B2) ein separat antreibbarer Halter (H2) zugeordnet ist.

7. Lötvorrichtung nach einem der Ansprüche 3 bis 6, mit vier paarweise einander gegenüberliegenden Bügelelektroden (B2),
**dadurch gekennzeichnet**,
daß die Bügelelektroden (B2) nacheinander paarweise auf die Lötstelle aufsetzbar sind.

## Claims

1. Soldering device having at least one bit electrode (B1;B2) whose rectangular working surface (A1;A2) can be placed onto the soldering point, characterized by the bit electrode (B1;B2) being suspended such that it can pivot with the normal to the centre of the longer sides of the working surface (A1;A2) as an offset rotation axis (Da1;Da2) lying in the plane of the working surface (A1;A2).

2. Soldering device according to Claim 1, characterized in that the bit electrode (B2) is mounted on a holder (H2), via a guide lever having two links (S1,S2) such that it can pivot about the adsorbed rotation axis (Da2).

3. Soldering device according to Claim 1 or 2, characterized in that the bit electrode (B2) is mounted on a holder (H2) such that it can pivot about the adsorbed rotation axis (Da2), and in that the holder (H2) is arranged such that it can be raised and lowered in the vertical direction (v) and can be moved outwards away from the soldering point in the horizontal direction (h).

4. Soldering device according to Claim 3, characterized in that the holder (H2) is rigidly connected to the connecting rod (K) of a four-link chain (Vk).

5. Soldering device according to Claim 4, characterized in that the coupling curve (Kk) of the four-link chain (Vk) runs exclusively in the vertical direction (v) in the vicinity of the soldering point, and in that the component in the horizontal direction (h) does not become greater until the distance from the soldering point increases.

6. Soldering device according to one of Claims 3 to 5, characterized in that each bit electrode (B2) has a holder (H2) allocated to it which can be driven separately.

7. Soldering device according to one of Claims 3 to 6, having four bit electrodes (B2) which are arranged opposite one another in pairs, characterized in that the bit electrodes (B2) can be placed on the soldering point successively in pairs.

## Revendications

1. Dispositif de brasage comprenant au moins une électrode en forme d'étrier (B1 ; B2), dont la surface active (A1 ; A2) de forme rectangulaire peut être posée sur le joint à braser,
caractérisé par une suspension pivotante de l'électrode en forme d'étrier (B1 ; B2), avec les médiatrices des côtés les plus longs de la surface active (A1 ; A2) en tant qu'axe de rotation décalé (Da1 ; Da2) situé dans le plan de la surface active (A1 ; A2).

2. Dispositif de brasage selon la revendication 1, caractérisé en ce que l'électrode en forme d'étrier (B2) est fixée à un porte-électrode (H2) par l'intermédiaire d'un guidage à bras oscillants, avec deux biellettes oscillantes (S1, S2), de manière à pivoter autour de l'axe de rotation décalé (Da2).

3. Dispositif de brasage selon la revendication 1 ou 2, caractérisé en ce que l'électrode en forme d'étrier (B2) est fixée à un porte-électrode (H2) de manière pivotante autour de l'axe de rotation décalé (Da2) et en ce que le porte-électrode (H2) est monté afin de pouvoir effectuer un mouvement ascendant et descendant dans la direction verticale (v) et de pouvoir être éloigné du joint à braser, vers l'extérieur dans la direction horizontale (h).

4. Dispositif de brasage selon la revendication 3, caractérisé en ce que le porte-électrode (H2) est relié rigidement à la bielle (K) d'une chaîne cinématique à quatre joints articulés (Vk).

5. Dispositif de brasage selon la revendication 4, caractérisé en ce que la trajectoire d'un point de la bielle (Kk) de la chaîne cinématique à quatre joints articulés (Vk) s'étend, à proximité du joint à braser, exclusivement dans la direction verticale (v) et en ce que la composante dans la direction horizontale (h) devient plus grande au fur et à mesure qu'augmente l'éloignement par rapport au joint à braser.

6. Dispositif de brasage selon l'une des revendications 3 à 5, caractérisé en ce qu'un porte-électrode (H2) pouvant être actionné séparément est associé à chaque électrode en forme d'étrier (B2).

7. Dispositif de brasage selon l'une des revendications 3 à 6, comprenant quatre électrodes en forme d'étrier (B2) disposées par paires de manière opposée,
caractérisé en ce que les électrodes en forme d'étrier (B2) peuvent être placées sur le joint à braser successivement par paires.
